# EUROPÄISCHE PATENTSCHRIFT

(11) **EP 0 810 547 B1**
(45) Veröffentlichungstag und Bekanntmachung des Hinweises auf die Patenterteilung: **19.04.2006**
(21) Anmeldenummer: 97108394.4
(22) Anmeldetag: 23.05.1997
(51) Int. Cl.: G06K 19/077

(54) **Verfahren zur Herstellung eines kartenförmigen Datenträgers**
Method for manufacturing a card shaped data carrier
Procédé de fabrication d'un porteur de données en forme de carte

(30) Priorität: 24.05.1996 DE 19621044
(43) Veröffentlichungstag der Anmeldung: 03.12.1997
(73) Patentinhaber: Giesecke & Devrient GmbH, 81677 München (DE)
(72) Erfinder: Hoppe, Joachim, 81377 München (DE)
(74) Vertreter: Klunker . Schmitt-Nilson . Hirsch

(56) Entgegenhaltungen:
- EP-A- 0 071 031
- EP-A- 0 671 705
- EP-A- 0 682 321
- EP-A- 0 689 164
- US-A- 5 023 751
- US-A- 5 057 679

## Beschreibung

Die Erfindung betrifft ein Verfahren zur Herstellung eines kartenförmigen Datenträgers mit einem integrierten Schaltkreis, wie beispielsweise eine Ausweiskarte, eine Bankkarte, eine Scheckkarte oder dergleichen.

Es sind bereits eine Reihe von Verfahren zur Herstellung von IC-Karten bekannt. Einen besonderen Aufwand verursacht bei den bekannten Verfahren in der Regel das Einbringen des IC in den Kartenkörper und das Aufbringen von Kontaktflächen auf den Kartenkörper bzw. das Anordnen einer Spule oder einer elektrostatischen Koppelfläche im Kartenkörper sowie die Herstellung einer elektrisch leitenden Verbindung zwischen den Kontaktflächen bzw. der Spule oder der elektrostatischen Koppelfläche und dem IC. Die Kontaktflächen und die Spule bzw. die elektrostatische Koppelfläche werden für die Kommunikation des IC mit externen Geräten benötigt. Diese Kommunikation kann dadurch erfolgen, daß ein galvanischer Kontakt zwischen dem externen Gerät und der IC-Karte hergestellt wird. Zu diesem Zweck wird eine Kontaktierungseinheit des externen Gerätes gegen die auf der Oberfläche der IC-Karte angeordneten Kontaktflächen gepreßt. Es ist jedoch auch eine berührungslose Kommunikation zwischen der IC-Karte und dem externen Gerät möglich, beispielsweise mittels elektromagnetischer Wellen, die von einer in der IC-Karte angeordneten Spule empfangen und beeinflußt werden können oder elektrostatisch über elektrostatische Koppelflächen. In der Regel wird man sich aus Kostengründen für eine der genannten Kopplungsarten entscheiden, d. h. man wird die IC-Karte entweder mit Kontaktflächen für eine kontaktierende Kopplung ausstatten oder mit einer Spule bzw. einer elektrostatischen Koppelfläche für eine kontaktfreie Kopplung. Es ist jedoch auch möglich, beide Kopplungsarten auf derselben IC-Karte zu realisieren, um beispielsweise eine möglichst universelle Einsetzbarkeit der IC-Karte zu ermöglichen.

Zur Herstellung von IC-Karten mit kontaktierender Kopplung verwendet man häufig vorgefertigte IC-Module, die einen IC und mit diesem IC verbundene Kontaktflächen aufweisen und die in eine Aussparung des Kartenkörpers eingebracht werden. Für das Bestücken der Kartenkörper mit den IC-Modulen stehen ausgereifte Techniken zur Verfügung, so daß hierbei in der Regel keine größeren Schwierigkeiten auftreten. Die Herstellung der IC-Module ist jedoch relativ aufwendig und damit kostenintensiv. Außerdem ist es erforderlich, daß IC-Modul und Kartenkörper genau aufeinander abgestimmt sind. Will man beispielsweise das Kontaktlayout ändern, so muß dafür ein neues IC-Modul hergestellt werden.

Für das Ausstatten eines Kartenkörpers mit einer Spule und das Kontaktieren der Spule an den IC hat sich unter der Vielzahl der möglichen Technologien bislang noch kein Verfahren eindeutig durchgesetzt. Die bekannten Verfahren unterscheiden sich jedoch in der Regel erheblich von den Techniken, die für die Herstellung von IC-Karten mit kontaktierender Kopplung eingesetzt werden. Die Spulen können beispielsweise aus Draht gewickelt werden, aufgedampft werden, aufgedruckt werden, aufgeätzt werden usw.

Eine elektrostatische Koppelfläche kann - ähnlich wie eine Spule - aufgedampft, aufgedruckt, aufgeätzt werden usw.

Aus der EP 0 689164 A2 ist ein Verfahren zur Herstellung von kontaktlosen Datenträgern bekannt, bei dem eine Spule auf einem Trägermaterial bereitgestellt wird. Mit einem Heißprägestempel wird die Spule in eine Aussparung einer Kartenfolie gebracht, so daß die Spule auf die Folie übertragen wird und der Trägerfilm entfernt werden kann. In einem weiteren Verfahrensschritt wird ein integrierter Schaltkreis in die Aussparung eingesetzt und über leitende Bonddrähte mit den Spulenenden verbunden.

Die Ansprüche sind gegen dieses Dokument abgegrenzt.

Aus der EP 0 671 705 A2 ist ein Herstellungsverfahren für eine Karte bekannt, die sowohl kontaktlos als auch kontaktbehaftet betrieben werden kann. Die Karte weist ein Modul mit Kontaktflächen auf, das derart in eine Aussparung eingesetzt wird, daß innerhalb der Aussparung liegende Antennenkontakte mit den Kontaktflächen des Moduls verbunden werden.

Die US 5,023,751 offenbart ein Verfahren zur Herstellung einer Chipkarte, bei der ein integrierter Schaltkreis auf einem mit isolierenden Folien beklebten und mit Aussparungen versehenen Kontaktfeld befestigt wird. Anschließend wird der integrierte Schaltkreis zusammen mit den Bonddrähten vergossen und ausgestanzt.

Um ein Modul in der Kavität einer Karte zu befestigen, schlägt die US 5,057,679 vor, einen Befestigungsring in die Kavität aufzunehmen, der mit einem thermisch aktivierbaren Klebstoff beschichtet ist. Unter Aufbringung von Druck und Hitze wird das Modul, welches aus einem integrierten Schaltkreis und daran befestigten Kontaktflächen besteht, in der Kavität dauerhaft fixiert.

Der Erfindung liegt die Aufgabe zugrunde, ein verbessertes Verfahren zur Herstellung von IC-Karten anzugeben.

Die Aufgabe wird durch die Merkmale der unabhängigen Ansprüche gelöst.

Der Grundgedanke der Erfindung besteht darin, bei der Herstellung von IC-Karten auf den Einsatz von vorgefertigten IC-Modulen zu verzichten, indem ein Kartenkörper mit einer Aussparung zur Aufnahme des IC bereitgestellt wird und ein Kontaktfeld zur Kommunikation mit externen Geräten mittels eines Prägeverfahrens auf den Kartenkörper aufgebracht wird und elektrisch leitend mit dem IC verbunden wird.

Die erfindungsgemäße Lösung hat den Vorteil, daß auf den Einsatz von teuren IC-Modulen verzichtet werden kann und dennoch eine rationelle Kartenfertigung möglich ist. Das Kontaktfeld zur Kommunikation mit externen Geräten wird von einem Transferband auf die Kartenoberfläche übertragen. Besonders vorteilhaft ist, daß das Kontaktfeld in einem nahezu beliebigen Layout realisiert werden kann. Zur Herstellung von Karten mit verschiedenen Layouts kann dabei sogar dasselbe Transferband verwendet werden. Ein weiterer Vorteil besteht darin, daß die Herstellung des Kontaktfeldes getrennt vom IC und vom Kartenkörper erfolgt, d. h. Kartenkörper und IC werden mit dem vollständig fertiggestellten Kontaktfeld in Verbindung gebracht. Dies hat den Vorteil, daß bei der Herstellung des Kontaktfeldes weder auf den IC noch auf den Kartenkörper Rücksicht genommen werden muß und somit die optimalen Prozeßparameter eingestellt werden können.

In einer bevorzugten Ausführungsform der Erfindung wird ein Kartenkörper mit einer Aussparung zur Aufnahme eines IC bereitgestellt. Der IC wird so in die Aussparung eingebracht, daß seine Kontakte nach außen weisen. Die Kontaktflächen werden mittels eines Prägestempels von einem Transferband auf den Kartenkörper in der Umgebung der Aussparung und auf die Kontakte des IC aufgepreßt. Die Kontakte des IC sind mit Lötperlen versehen, so daß durch Erhitzen dieser Lötperlen eine leitende Verbindung zwischen den Kontakten des IC und den einzelnen Kontaktflächen hergestellt werden kann. Danach wird der verbleibende Hohlraum der Aussparung mit einer Ausfüllmasse abgedeckt.

Die verschiedenen Ausführungsformen der Erfindung werden anhand der nachstehenden Figuren erläutert. Es zeigen:
- Fig.1: eine IC-Karte in Aufsicht,
- Fig. 2a: eine IC-Karte, deren Kontaktflächen direkt mit der Oberseite des IC verbunden sind, in Schnittdarstellung,
- Fig. 2b: eine IC-Karte, deren Kontaktflächen über Kontaktfinger mit der Oberseite des IC verbunden sind, in Schnittdarstellung,
- Fig. 2c: eine IC-Karte, deren Kontaktflächen über Bonddrähtchen mit der Oberseite des IC verbunden sind, in Schnittdarstellung,
- Fig. 3: eine IC-Karte, deren Kontaktflächen direkt mit der Unterseite des IC verbunden sind, in Schnittdarstellung,
- Fig. 4: eine IC-Karte, deren Kontaktflächen über mit einem leitfähigen Material ausgefüllte Kanäle mit der Oberseite des IC verbunden sind, in Schnittdarstellung,
- Fig. 5: eine IC-Karte mit Kontaktflächen und Spule in Schnittdarstellung, wobei die Kontaktflächen und die Spule über Bonddrähtchen mit der Oberseite des IC verbunden sind,
- Fig. 6: ein Transferband in Schnittdarstellung,
- Fig. 7: ein Transferband, das sich zur Herstellung der in Fig. 2a dargestellten IC-Karte eignet, in Aufsicht,
- Fig. 8: ein Transferband, das sich zur Herstellung der in Fig. 3 dargestellten IC-Karte eignet, in Aufsicht,
- Fig. 9: ein Transferband, das sich zur Herstellung der in Fig. 4 dar- gestellten IC-Karte eignet, in Aufsicht,
- Fig.10: ein Transferband, das sich zur Herstellung der in Fig. 5 dargestellten IC-Karte eignet, in Aufsicht,
- Fig. 11: ein Transferband, das sich zur Herstellung der in Fig. 2b dargestellten IC-Karte eignet, in Aufsicht,
- Fig. 12a-12d: verschiedene Ausführungsformen für die Anordnung der Bonddrähtchen der in Fig. 2c dargestellten IC-Karte
- Fig.13: eine Anordnung zum Aufbringen der Kontakflächen auf den Kartenkörper in Schnittdarstellung und
- Fig.14: eine weitere Anordnung zum Aufbringen der Kontaktflächen auf den Kartenkörper in Schnittdarstellung.

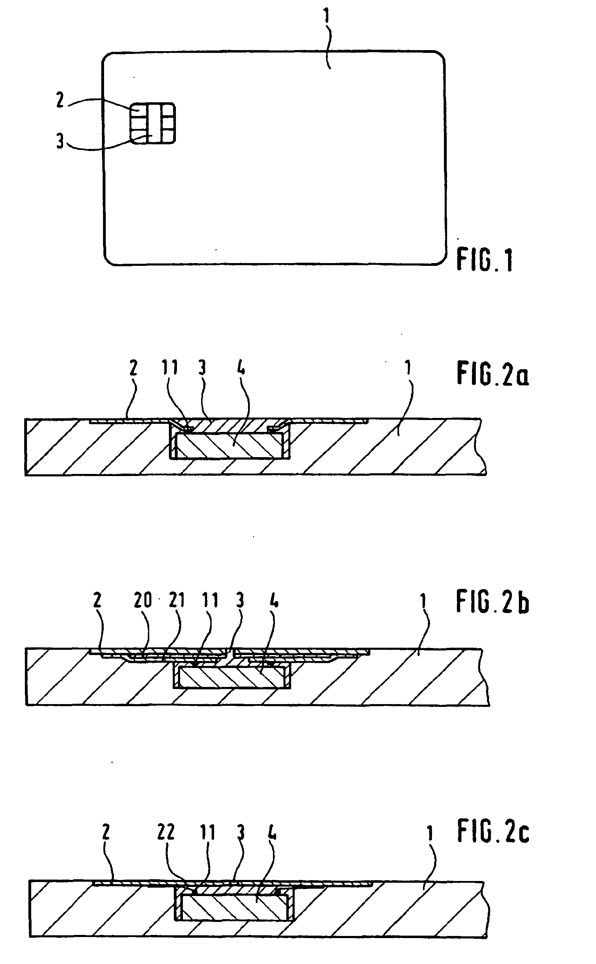

Fig. 1 zeigt eine IC-Karte 1 in Aufsicht. An einer durch die ISO-Norm festgelegten Position der Kartenoberfläche sind Kontaktflächen 2 angeordnet, über die eine galvanische Verbindung zwischen einem externen Gerät und einem in der Karte befindlichen IC 4 hergestellt werden kann (vgl. Fig. 2a). Der IC 4 befindet sich in einer Aussparung des Kartenkörpers und wird von einer Vergußmasse 3 abgedeckt. Der Kartenkörper kann bedruckt sein und weitere Elemente aufweisen, wie z. B. einen Magnetstreifen, einen Unterschriftsstreifen, eine Fotografie, ein Hologramm usw. Der Kartenkörper kann aus einer oder aus mehreren Schichten bestehen. Als bevorzugtes Material für den Kartenkörper wird Kunststoff verwendet. Abhängig von der Anwendung können jedoch auch andere Materialien zur Herstellung des Kartenkörpers verwendet werden, wie beispielsweise Papier oder Karton.

Die Fig. 2a, 2b und 2c zeigen jeweils die IC-Karte 1 in Schnittdarstellung. Die Kontaktflächen 2 schließen bündig mit der Oberfläche der IC-Karte 1 ab. Der IC 4 ist in einer Aussparung des Kartenkörpers angeordnet. Die Kontakte des IC 4 zeigen zur Öffnung der Aussparung hin, d. h. der IC 4 ist an seiner Oberseite kontaktiert.

Bei dem in Fig. 2a dargestellten Ausführungsbeispiel sind die Kontaktflächen 2 direkt über Lötperlen 11 mit den Kontakten des IC 4 verbunden. Die Aussparung des Kartenkörpers, in der der IC 4 angeordnet ist, ist bis zur Kartenoberfläche mit der Vergußmasse 3 aufgefüllt.

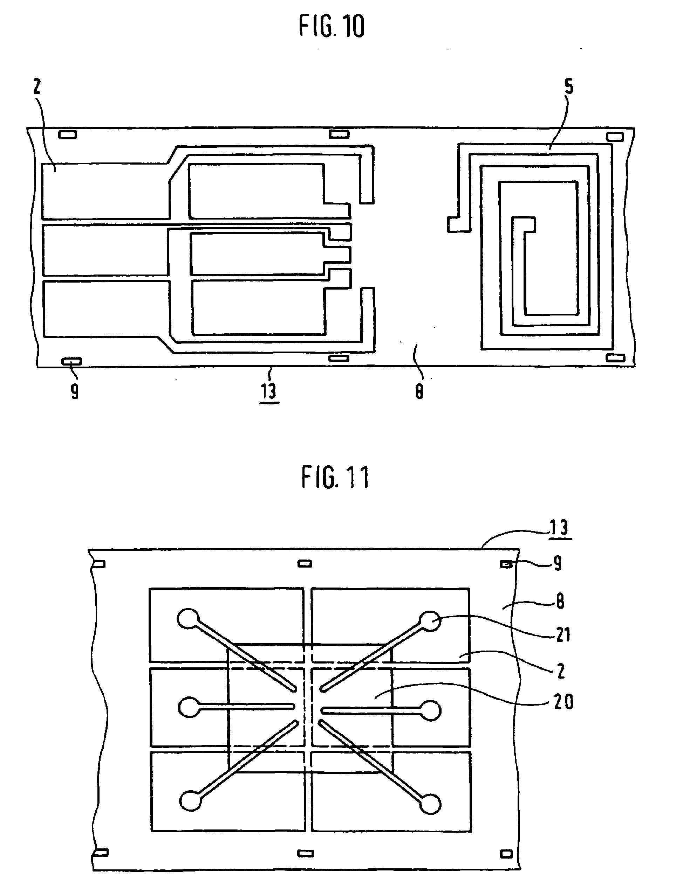

Bei dem Ausführungsbeispiel gemäß Fig. 2b wird die Aussparung des Kartenkörpers nahezu vollständig durch die Kontaktflächen 2 abgedeckt. Es verbleiben lediglich kleine Zwischenräume zwischen den einzelnen Kontaktflächen 2, um diese voneinander elektrisch zu isolieren. Wie in Fig. 11 im einzelnen dargestellt, wird die weitgehende Abdeckung der Aussparung durch die Kontaktflächen 2 dadurch ermöglicht, daß die Kontaktflächen 2 über je einen Kontaktfinger 21 mit den Lötperlen 11 des IC 4 verbunden sind. Durch eine Isolierschicht 20, die bereichsweise auf die Kontaktflächen aufgebracht ist, sind die einzelnen Kontaktfinger 21 von den Kontaktflächen 2, die ihnen nicht zugeordnet sind, elektrisch isoliert. Die Isolierschicht 20 und die Kontaktfinger 21 werden bevorzugt so ausgelegt, daß sie sich nicht miteinander verbinden. Durch die damit entstehende Beweglichkeit oder Kontaktfinger 21 wird einer Beschädigung der Kontaktfinger 21 bei mechanischer Beanspruchung der IC-Karte 1 vorgebeugt. Ein nach der Montage des IC 4 und der Kontaktflächen 2 samt Isolierschicht 20 und Kontaktfinger 21 gegebenenfalls verbleibender Hohlraum kann durch die Vergußmasse 3 aufgefüllt werden. Wenn der IC 4 sehr genau in die Aussparung eingepaßt ist und auf seiner Kontaktseite eine Isolierschicht trägt, in die die Lötperlen eingelassen sind, kann auf die Vergußmasse 3 verzichtet werden. Auch bei einer Fertigung des Kartenkörpers in Spritzgußtechnik, bei der der IC 4 so in den Kartenkörper eingespritzt ist, daß lediglich Zugänge zu den Lötperlen 11 verbleiben, kann auf die Vergußmasse 3 verzichtet werden.

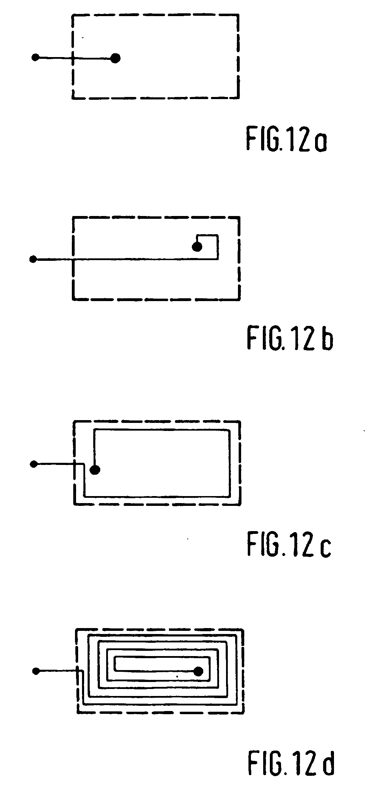

In Fig. 2c ist ein Ausführungsbeispiel dargestellt, bei dem die Aussparung ebenfalls weitgehend durch die Kontaktflächen 2 abgedeckt ist. Die Verbindung zwischen den Kontaktflächen 2 und den Lötperlen 11 des Chips erfolgt bei diesem Ausführungsbeispiel über Bonddrähte 22, die vor dem Aufbringen der Kontaktflächen 2 an die Lötperlen 11 kontaktiert und im Bereich der aufzubringenden Kontaktflächen 2 an der Kartenoberfläche verlegt werden. Verschiedene Verlegemuster sind in den Fig. 12a bis 12d dargestellt. Bezüglich der Vergußmasse 3 gilt das zu Fig. 2b Gesagte.

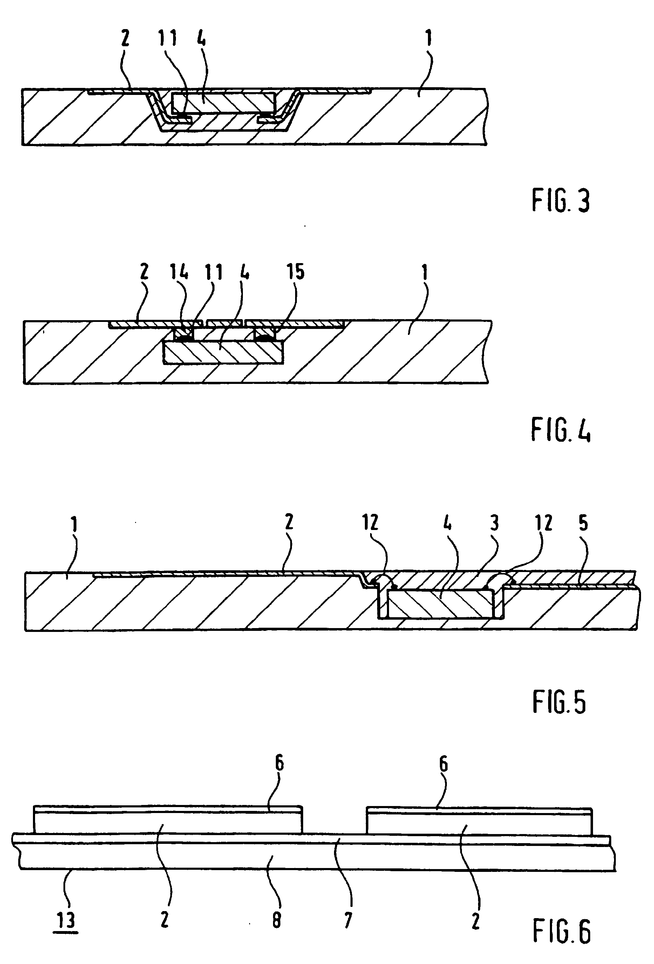

Fig. 3 zeigt eine weitere Ausführungsform der IC-Karte 1. Die in Fig. 3 dargestellte Ausführungsform entspricht weitgehend der Ausführungsform aus Fig. 2a. Im Unterschied zur Fig. 2a wird in Fig. 3 der IC 4 jedoch an seiner Unterseite kontaktiert, d. h. die Kontakte des IC 4 zeigen zum Boden der Aussparung des Kartenkörpers hin.

Fig. 4 zeigt eine Ausführungsform der IC-Karte 1, bei der der IC 4 in einen Spritzguß-Kartenkörper eingespritzt ist. Die Kontaktflächen 2 sind über ein leitfähiges Material 14, mit dem Kanäle 15 aufgefüllt sind, mit den Kontakten des IC 4 verbunden. Bei dem leitfähigen Material 14 kann es sich beispielsweise um einen Leitkleber handeln. Die Kanäle 15 verlaufen jeweils von den Kontakten des IC 4 zur Kartenoberfläche und werden entweder bereits beim Spritzgießen des Kartenkörpers erzeugt oder nachträglich durch Bohren oder eine ähnliche Technik hergestellt. Vor dem Aufbringen der Kontaktflächen 2 werden die Kanäle 15 mit dem leitfähigen Material 14 aufgefüllt.

In Fig. 5 ist ein Schnitt durch eine IC-Karte 1 dargestellt, die sowohl über Kontaktflächen 2 als auch über eine Spule 5 verfügt. Der IC 4 ist so in der Aussparung der IC-Karte 1 angeordnet, daß seine Kontakte zur Öffnung der Aussparung hin zeigen, d. h. die Anordnung des IC 4 entspricht der in Fig. 2 dargestellten Anordnung. Die Kontaktflächen 2 und die Spule 5 sind auf gegenüberliegenden Seiten neben dem IC 4 angeordnet und über Bonddrähtchen 12 mit den entsprechenden Kontakten des IC 4 verbunden. Die Kontaktflächen 2 sind so auf der Kartenoberfläche angeordnet, daß ihre Oberseite mit der Kartenoberfläche in einer Ebene liegt. Die Spule 5 befindet sich in einer Vertiefung des Kartenkörpers, die sich an die Aussparung für den IC 4 anschließt, und ist mit der Vergußmasse 3 oder einer Abdeckfolie abgedeckt, so daß sich insgesamt eine ebene Kartenoberfläche ergibt. Die in Fig. 5 dargestellte IC-Karte 1 kann mit einem externen Gerät sowohl über die Kontaktflächen 2 als auch über die Spule 5 in Verbindung treten. Der in Fig. 5 dargestellte Kartenaufbau kann auch bei IC-Karten 1 angewendet werden, die nur über Kontaktflächen 2 verfügen und nicht mit einer Spule 5 ausgestattet sind. In diesem Fall wird man die Kontaktflächen 2 in der Regel zu beiden Seiten des IC 4 anordnen, wie dies auch in den Fig. 2 und 3 der Fall ist. Weiterhin kann der in Fig. 5 dargestellte Kartenaufbau auch bei IC-Karten 1 eingesetzt werden, die ausschließlich für einen kontaktlosen Datenaustausch vorgesehen sind und daher nicht über Kontaktflächen 2 verfügen. Hierzu kann der in Fig. 5 dargestellte Kartenaufbau in identischer Weise beibehalten werden, wobei lediglich die Kontaktflächen 2 entfallen.

Fig. 6 zeigt ein Transferband 13, das bei dem erfindungsgemäßen Verfahren eingesetzt wird, in Schnittdarstellung. Das Transferband 13 besteht aus einer Trägerfolie 8, auf der die Kontaktflächen 2 aufgebracht sind. Die Kontaktflächen 2 sind durch eine Trennschicht 7 von der Trägerfolie 8 getrennt, so daß eine Übertragung der Kontaktflächen 2 vom Transferband 13 auf die IC-Karte 1 möglich ist. Auf der der Trennschicht 7 gegenüberliegenden Seite sind die Kontaktflächen 2 mit einer Kleberschicht 6 versehen. Die Kleberschicht 6 dient dazu, eine dauerhafte Verbindung zwischen der Oberfläche der IC-Karte 1 und den Kontaktflächen 2 herzustellen. Das Transferband kann auch einen komplexeren Aufbau besitzen, wie beispielsweise in Fig. 11 dargestellt.

Zur Fertigung des Transferbandes 13 können unterschiedliche Verfahren eingesetzt werden. So können die Kontaktflächen 2 auf die Trennschicht 7 aufgedampft werden oder galvanisch auf der Trennschicht 7 abgeschieden werden oder auch als Folie auf die Trennschicht 7 aufgebracht oder als leitfähige Schichten aufgedruckt oder beschichtet werden, usw. Die Umrisse der Kontaktflächen 2 können durch entsprechende Masken hergestellt werden, gegebenenfalls in Verbindung mit einem geeigneten Ätzverfahren oder Druckverfahren. Die Umrisse der Kontaktflächen 2 können aber auch durch einen entsprechenden Prägestempel aus einer geschlossenen Schicht herausgeprägt werden. Weiterhin können die Umrisse auch durch eine mechanische Entfernung des überschüssigen Materials erzeugt werden oder die Kontaktflächen 2 können bereits in ihrer endgültigen Form auf die Trennschicht 7 aufgebracht werden. Statt der Kontaktflächen 2 kann die Trägerfolie 8 auch Spulen 5 bzw. elektrostatische Koppelflächen tragen und es können auch mehrere dieser Strukturen auf demselben Transferband 13 vorhanden sein. Insbesondere ist es auch möglich, auf einem Transferband 13 unterschiedliche Kontaktlayouts anzuordnen.

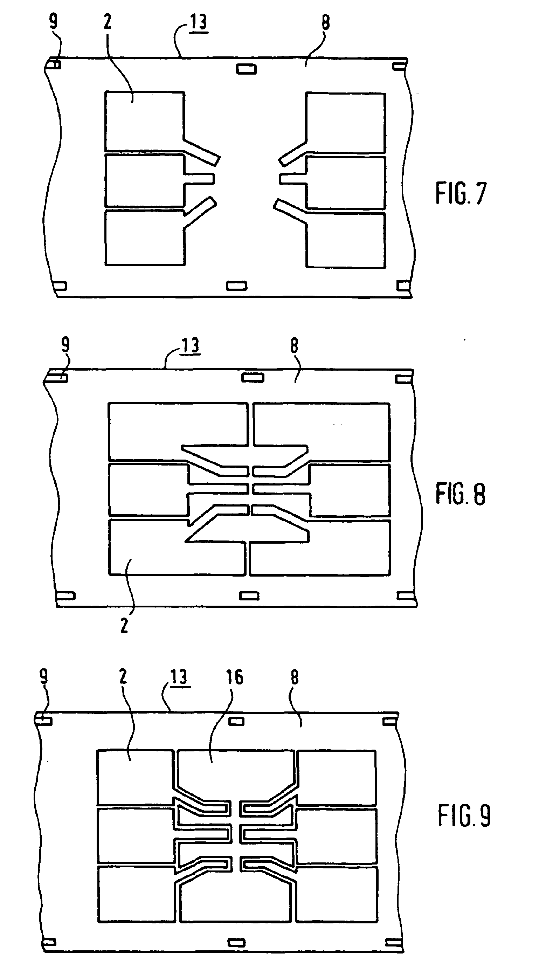

Fig. 7 zeigt einen Ausschnitt aus dem Transferband 13 in Aufsicht. Der in Fig. 7 dargestellte Bereich des Transferbands 13 trägt Kontaktflächen 2, die zur Herstellung der in Fig. 2a dargestellten IC-Karte 1 geeignet sind. Die Kontaktflächen 2 weisen längliche Fortsätze auf, über die elektrisch leitende Verbindungen zu den entsprechenden Kontakten des IC 4 hergestellt werden können. Der Trägerfilm 8, der die Kontaktflächen 2 trägt, weist Transportlöcher 9 auf, mit deren Hilfe das Transferband 13 so positioniert werden kann, daß die Kontaktflächen 2 genau gegenüber den dafür vorgesehenen Positionen auf der Oberfläche der IC-Karte 1 zu liegen kommen. Die in Fig. 7 dargestellten Kontaktflächen 2 werden auf eine IC-Karte 1 aufgebracht, in deren Aussparung sich bereits ein IC 4 befindet, wobei die länglichen Fortsätze auf den Kontakten des IC 4 zu liegen kommen.

Fig. 8 zeigt einen weiteren Ausschnitt aus dem Transferband 13 in Aufsicht. Die in diesem Ausschnitt dargestellten Kontaktflächen 2 sind zur Herstellung der in Fig. 3 dargestellten IC-Karte 1 geeignet, d. h. die Kontaktflächen 2 werden an der IC-Karte 1 angebracht, bevor der IC 4 in die Aussparung der IC-Karte 1 eingesetzt wird. Sowohl bei den in Fig. 7 dargestellten Kontaktflächen als auch bei den in Fig. 8 dargestellten Kontaktflächen 2 ist es vorgesehen, daß die galvanische Verbindung zwischen den Kontaktflächen 2 und den Kontakten des IC 4 mittels Lötperlen 11 hergestellt wird, die auf den Kontakten des IC 4 angeordnet sind. Die Fortsätze der Kontaktflächen 2 sind daher jeweils so gestaltet, daß sie nach dem Aufbringen der Kontaktflächen 2 auf die IC-Karte 1 die Lötperlen 11 des IC 4 überdecken. Durch Erhitzen der Lötperlen 11 kann dann eine galvanische Verbindung zwischen den Kontaktflächen 2 und den Kontakten des IC 4 hergestellt werden. Die in den Fig. 7 und 8 dargestellten Kontaktflächen 2 eignen sich auch für andere Verbindungstechniken. Beispielsweise können die Fortsätze der Kontaktflächen 2 auch mittels eines leitfähigen Klebers mit den Kontakten des IC 4 verklebt werden.

Fig. 9 zeigt wiederum einen Ausschnitt aus dem Transferband 13. Der in Fig. 9 dargestellte Bereich des Transferbands 13 trägt Kontaktflächen 2, die zur Herstellung der in Fig. 4 dargestellten IC-Karte 1 geeignet sind. Zwischen den Kontaktflächen 2 ist eine flächige Struktur 16 sichtbar, die beispielsweise der Abschirmung des IC 4 gegen elektromagnetische Felder, als Schutz vor elektrostatischer Aufladung oder auch nur der Veredelung der Kartenoberfläche dient. Eine derartige Struktur 16 kann auch bei dem in Fig. 7 dargestellten Kontaktflächen 2 vorgesehen werden.

Fig. 10 zeigt eine Aufsicht auf einen Ausschnitt des Transferbands 13 mit Kontaktflächen 2 und einer Spule 5. Dieser Ausschnitt des Transferbands eignet sich zur Herstellung der in Fig. 5 dargestellten IC-Karte 1. Die Fortsätze der Kontaktflächen 2 und der Spule 5 sind relativ kurz gehalten, da bei der in Fig. 4 dargestellten IC-Karte 1 die Kontakte des IC 4 nicht von den Fortsätzen überdeckt werden, sondern neben dem IC 4 zu liegen kommen und die galvanische Verbindung zwischen Kontaktflächen 2 bzw. Spule 5 und den entsprechenden Kontakten des IC 4 jeweils über Bonddrähtchen 12 hergestellt wird. Diese Bondtechnik kann auch bei IC-Karten 1 eingesetzt werden, die ausschließlich über Kontakte 2 oder ausschließlich über eine Spule 5 verfügen. Damit die Kontakte des IC 4 für den Bondvorgang zugänglich sind, wird der IC 4 so in der Aussparung der IC-Karte 1 plaziert, daß seine Kontakte zur Öffnung der Aussparung hinweisen. Im Gegensatz zu dem in Fig. 2c dargestellten Ausführungsbeispiel wird bei der hier angewendeten Bondtechnik der Bonddraht nach dem Kontaktieren des IC 4 nicht an die Kartenoberfläche geführt und dort verlegt, sondern an die Kontakte 2 und die Spule 5 kontaktiert, die bereits vor dem Bonden auf die IC-Karte 1 aufgebracht wurden.

Fig. 11 zeigt einen Ausschnitt aus dem Transferband 13 mit einer Struktur, die sich zur Herstellung der in Fig. 2b dargestellten IC-Karte 1 eignet. Die Kontaktflächen 2 sind rechteckig und ohne Fortsätze für die Kontaktierung ausgeführt und dicht nebeneinander auf der Trägerfolie 8 angeordnet. Zwischen den einzelnen Kontaktflächen 2 werden lediglich kleine Spalte eingehalten, um die Kontaktflächen 2 voneinander elektrisch zu isolieren. In Fig. 11 sind sechs Kontaktflächen abgebildet, die in zwei Dreierreihen zu einem Kontaktfeld gruppiert sind. Im Zentrum des Kontaktfelds ist auf die Kontaktflächen 2 eine Isolierschicht 20 aufgebracht, die die Kontaktflächen 2 bereichsweise abdeckt. Jeder Kontaktfläche 2 ist ein Kontaktfinger 21 zugeordnet, der im äußeren Bereich des Kontaktfeldes elektrisch leitend mit der jeweiligen Kontaktfläche 2 verbunden ist und sich von dort in Richtung auf den zentralen Bereich des Kontaktfeldes erstreckt. Der Kontaktfinger 21 verläuft somit im Außenbereich des Kontaktfeldes direkt auf der Kontaktfläche 2 und weiter im Zentrum des Kontaktfeldes auf der Isolierschicht 20. Das im Zentrum des Kontaktfelds gelegene Ende des Kontaktfingers 21 ist so positioniert, daß es bei der Übertragung der Struktur vom Transferband 13 auf die IC-Karte 1 genau auf dem entsprechenden Kontakt bzw. der entsprechenden Lötperle 11 des IC 4 zu liegen kommt.

Eine Abwandlung des in Fig. 11 dargestellten Ausführungsbeispiels eignet sich zur Herstellung der in Fig. 2c abgebildeten IC-Karte 1. Bei dieser Abwandlung entfallen die Kontaktfinger 21 vollständig und die Isolierschicht 20 ist auf einen wesentlich kleineren Bereich im Zentrum des Kontaktfeldes beschränkt, der nur so groß sein muß, daß darin die Bonddrähtchen 22 von den Kontakten bzw. den Lötperlen 11 des IC 4 zu den Bereichen der Kartenoberfläche geführt werden können, in denen die Kontaktflächen 2 zu liegen kommen.

Die Fig. 12a bis 12d zeigen verschiedene Ausführungsformen für die Anordnung der Bonddrähtchen 22 an der Oberfläche der in Fig. 2c dargestellten IC-Karte 1. Die einzelnen Anordnungen unterscheiden sich im wesentlichen durch die Fläche, die durch die Anordnung bedeckt wird. Je kleiner die von den Bonddrähtchen 22 abgedeckte Fläche ist, desto einfacher und kostengünstiger kann man die Anordnung realisieren. Je größer die von den Bonddrähtchen 22 abgedeckte Fläche ist, desto zuverlässiger ist der Kontakt mit der entsprechenden Kontaktfläche 2. In allen Fällen kommt der elektrische Kontakt zwischen dem Bonddrähtchen 22 und der Kontaktfläche 2 jeweils beim Aufprägen der Kontaktfläche auf den Kartenkörper zustande.

Bei der in Fig. 12a dargestellten Ausführungsform ist das Bonddrähtchen 22 mit einer relativ geringen Überdeckung in gerader Linie in den Bereich der Kontaktfläche 2 hineingeführt.

Im Ausführungsbeispiel gemäß Fig. 12b beschreibt das Bonddrähtchen 22 im Bereich der Kontaktfläche 2 eine kleine Schlaufe.

Im Ausführungsbeispiel gemäß Fig. 12c beschreibt das Bonddrähtchen 22 ebenfalls eine Schlaufe, die sich jedoch im Gegensatz zur Fig. 12b an den Au-ßenabmessungen der Kontaktfläche 2 orientiert.

Im Ausführungsbeispiel gemäß Fig. 12d ist das Bonddrähtchen 22 im Bereich der Kontaktfläche 2 spiralförmig verlegt und deckt somit eine relativ große Fläche ab.

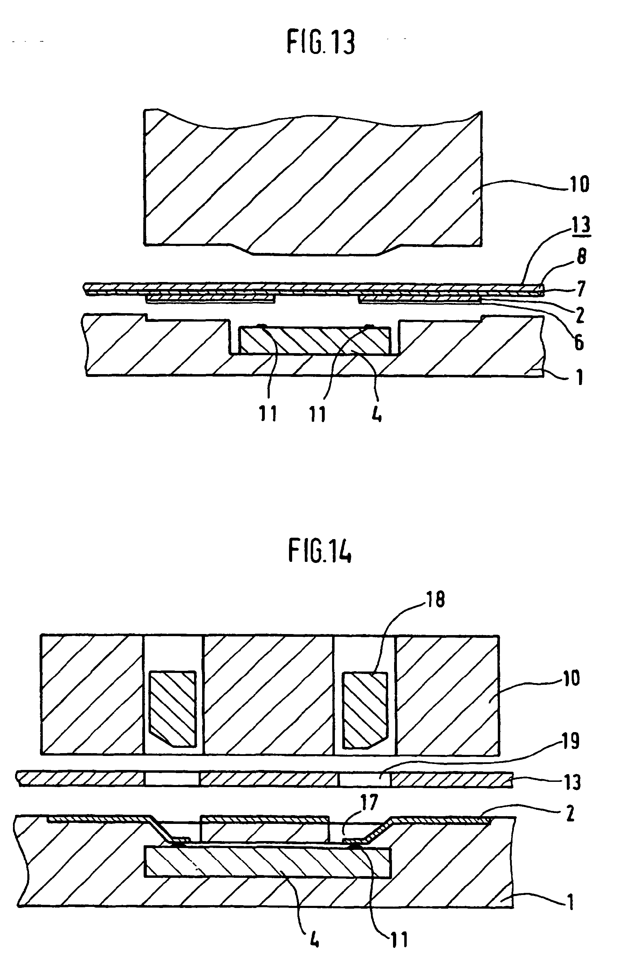

Fig. 13 zeigt eine Schnittdarstellung einer Anordnung zum Übertragen der Kontaktflächen 2 und/oder der Spule 5 bzw. der elektrostatischen Koppelfläche vom Transferband 13 auf die IC-Karte 1. In Fig. 13 ist beispielhaft der Chipkartenaufbau gemäß Fig. 2a dargestellt. Die in Fig. 13 gezeigte Anordnung eignet sich jedoch auch - mit geringfügigen Modifikationen - für andere Chipkartenaufbauten.

Das Transferband 13 ist zwischen der IC-Karte 1 und einem Stempel 10 angeordnet, wobei die Trägerfolie 8 der Stirnseite des Stempels 10 zugewandt ist und die Kleberschicht 6 der Kontaktflächen 2 der IC-Karte 1 zugewandt ist. Mit Hilfe der Transportlöcher 9 wird das Transferband 13 so positioniert, daß die auf dem Transferband 13 angeordneten Kontaktflächen 2 genau über den dafür vorgesehenen Positionen auf der IC-Karte 1 zu liegen kommen. Anschließend wird der Stempel 10 abgesenkt, so daß die Kontaktflächen 2 gegen die IC-Karte 1 gepreßt werden. Durch die Kleberschicht 6 auf den Kontaktflächen 2 entsteht beim Aufpressen der Kontaktflächen 2 auf die IC-Karte 1 eine dauerhafte Verbindung. Die Stirnseite des Stempels 10 ist so geformt, daß sich die Kontaktflächen 2 an die Oberflächenkontur der IC-Karte 1 und an die Kontakte des IC 4 anschmiegen. Die Kleberschicht 6 ist nicht in jedem Falle erforderlich. Z. B. kann bei Leitkleber-Strukturen oder bei einem Anspritzvorgang (bei Spritzgußkarten) darauf verzichtet werden.

In einer bevorzugten Ausführungsform besteht die Kleberschicht 6 aus einem thermoaktivierbaren Kleber. Bei dieser Ausführungsform wird der Stempel 10 beheizt, so daß die Kleberschicht 6 beim Anpressen des Stempels '10 aktiviert wird und mit der IC-Karte 1 verklebt. Da die Kontaktflächen 2 nur sehr schwach an die Trennschicht 7 des Transferbandes 13 gebunden sind, lösen sich die Kontaktflächen 2 beim Anpressen des Transferbandes 13 gegen die IC-Karte 1 von der Trennschicht 7 und verbleiben beim Zurückfahren des Stempels 10 auf der IC-Karte 1. Statt des thermoaktivierbaren Klebers kann beispielsweise auch ein Kontaktkleber verwendet werden, der beim Anpressen der Kontaktflächen 2 an die IC-Karte 1 mit der IC-Karte 1 verklebt. In diesem Fall braucht der Stempel 10 nicht beheizt zu werden.

Zur Herstellung der galvanischen Verbindung zwischen den Kontakten des IC 4 und den Kontaktflächen 2 kann auf den Kontakten des IC 4 eine Lötperle 11 angeordnet sein, die beim oder nach dem Aufpressen der Kontaktflächen 2 zum Schmelzen gebracht wird und sich dabei mit den Kontaktflächen 2 verbindet. Alternativ dazu kann aber auch ein leitfähiger Kleber auf den Kontakten des IC 4 oder auf den entsprechenden Positionen der Kontaktflächen 2 aufgebracht sein, der beim kalten oder beim heißen Aufpressen der Kontakte 2 auf die IC-Karte 1 eine galvanische Verbindung zwischen den Kontaktflächen 2 und den Kontakten des IC 4 herstellt.

Nachdem die Kontaktflächen 2 auf der IC-Karte 1 aufgebracht sind, und eine leitende Verbindung zu den Kontakten des IC 4 hergestellt wurde, wird der verbleibende Hohlraum der Aussparung der IC-Karte 1 mit einer Vergußmasse 3 aufgefüllt, so daß sich eine ebene Oberfläche ergibt.

In einer Variante der Erfindung, bei der der IC 4 von der Unterseite her kontaktiert wird, d. h. die Kontakte des IC 4 sind dem Boden der Aussparung in der IC-Karte 1 zugewandt, werden zunächst die Kontaktflächen 2 auf die geschilderte Art und Weise auf die IC-Karte 1 aufgepreßt. Anschließend wird der IC 4 mit seinen Kontakten auf die in der Aussparung der IC-Karte 1 befindlichen Fortsätze der Kontaktflächen 2 aufgesetzt und es wird eine galvanische Verbindung zwischen den Kontakten des IC 4 und den Kontaktflächen 2 hergestellt. Schließlich wird noch der verbleibende Hohlraum mit der Vergußmasse 3 aufgefüllt.

Falls die galvanische Verbindung zwischen den Kontaktflächen 2 und den Kontakten des IC 4 mittels Bonddrähtchen 12 hergestellt wird, kann der IC 4 wahlweise vor oder nach dem Aufpressen der Kontaktflächen 2 bzw. der Spule 5 in die Aussparung der IC-Karte 1 eingesetzt werden. Abhängig von der Größe des IC 4 und vom Kontaktflächen- und/oder Spulenlayout kann es vorkommen, daß die Kontaktflächen 2 und/ oder die Spule 5 so weit in die Aussparung hineinragen, daß der IC nachträglich nicht mehr eingesetzt werden kann. In diesem Fall besteht nur die Möglichkeit, den IC 4 vor dem Aufbringen der Kontaktflächen 2 und/oder der Spule 5 auf die IC-Karte 1 in der Aussparung anzuordnen. Nachdem die Kontaktflächen 2 und/oder die Spule 5 auf die IC-Karte 1 aufgebracht sind und der IC 4 in der Aussparung der IC-Karte 1 angeordnet ist, werden die galvanischen Verbindungen zwischen den Kontaktflächen 2 bzw. der Spule 5 und den entsprechenden Kontakten des IC 4 durch Anbringen der Bonddrähtchen 12 hergestellt und anschließend wird der verbleibende Hohlraum mit der Vergußmasse 3 aufgefüllt, so daß sich eine ebene Oberfläche ergibt.

Fig. 14 zeigt eine weitere Anordnung zum Aufbringen der Kontaktflächen 2 auf den Kartenkörper. Im Gegensatz zu Fig. 13 ist in Fig. 14 der Zustand nach dem Übertragen der Kontaktflächen 2 vom Transferband 13 auf die Kartenoberfläche dargestellt.

Bei der in Fig. 14 gezeigten IC-Karte 1 handelt es sich um eine Spritzguß-Karte, in die der IC 4 eingespritzt ist. Gegenüber den Kontakten des IC 4 sind Aussparungen 17 vorgesehen, in die die länglichen Fortsätze der Kontaktflächen 2 hineingepreßt und beispielsweise mittels Lötperlen 11 mit den Kontakten des IC 4 kontaktiert werden können. Zum Einpressen der länglichen Fortsätze der Kontaktflächen 2 sind im Stempel 10 Hilfsstempel 18 integriert, die unabhängig vom Stempel 10 bewegbar sind. Auf diese Weise läßt sich der Anpreßdruck, mit dem die länglichen Fortsätze in die Aussparungen 17 gepreßt werden, getrennt vom Anpreßdruck, mit dem die Kontaktflächen 2 gegen die Kartenoberfläche gepreßt werden, regulieren. Beim Anpressen der länglichen Fortsätze der Kontaktflächen 2 werden die Hilfsstempel 18 durch Durchbrüche 19 im Trägerband 13 geführt.

Mehrteilige Stempel 10, 18 können auch bei Kontaktlayouts und Kartenaufbauten eingesetzt werden, die von dem in Fig. 14 dargestellten abweichen. Umgekehrt ist es auch möglich, die in Fig.14 dargestellte IC-Karte 1 mittels eines einteiligen Stempels 10 herzustellen, bei dem die Hilfsstempel 18 angeformt sind.

## Patentansprüche

1. Verfahren zur Herstellung eines kontaktbehafteten kartenförmigen Datenträgers (1) mit einem integrierten Schaltkreis (4) und leitend mit dem integrierten Schaltkreis (4) verbundenen Kontaktmitteln (2, 5) zur Kommunikation mit externen Geräten, wobei
- ein Kartenkörper bereitgestellt wird, mit wenigstens einer Aussparung zur Aufnahme des integrierten Schaltkreises (4),
- der integrierte Schaltkreis (4) in die Aussparung eingesetzt wird,
- das Kontaktmittel (2, 5) vor oder nach dem Einsetzen des integrierten Schaltkreises in die Aussparung von einem Transferband (13) auf den Kartenkörper übertragen wird, indem ein Stempel (10) das Transferband (13) mit dem Kontaktmittel (2, 5) von der dem Kontaktmittel (2, 5) gegenüberliegenden Seite her gegen den kartenförmigen Datenträger (1) preßt,
- eine leitende Verbindung zwischen dem Kontaktmittel (2, 5) und den Kontakten des integrierten Schaltkreises (4) hergestellt wird,
**dadurch gekennzeichnet, daß**
- das Kontaktmittel (2, 5) aus einem Kontaktfeld mit einer Anzahl elektrisch voneinander isolierter Kontaktflächen besteht,
- der verbleibende Hohlraum der Aussparung nach Einsetzen des integrierten Schaltkreises (4), Aufbringen des Kontaktfeldes (2, 5) und Herstellung der leitenden Verbindungen mit einer Vergussmasse (3) aufgefüllt wird, derart, daß sich eine ebene Oberfläche ergibt.

2. Verfahren nach Anspruch 1, **dadurch gekennzeichnet, daß** das Transferband (13) aus einer Trägerfolie (8) und einer zwischen der Trägerfolie (8) und dem Kontaktfeld (2, 5) angeordneten Trennschicht (7) besteht.

3. Verfahren nach Anspruch 2, **dadurch gekennzeichnet, daß** das Transferband (13) vor dem Aufpressen des Kontaktfeldes (2, 5) so gegenüber dem kartenförmigen Datenträger (1) positioniert wird, daß das Kontaktfeld (2, 5) über den dafür vorgesehenen Bereichen des kartenförmigen Datenträgers (1) zu liegen kommt.

4. Verfahren nach einem der vorhergehenden Ansprüche, **dadurch gekennzeichnet, daß** das Kontaktfeld (2, 5) mit dem kartenförmigen Datenträger (1) verklebt wird.

5. Verfahren nach einem der vorhergehenden Ansprüche, **dadurch gekennzeichnet, daß** eine leitende Verbindung zwischen dem Kontaktfeld (2, 5) und den Kontakten des integrierten Schaltkreises (4) mittels eines leitfähigen Klebers oder über Lötperlen hergestellt wird.

6. Verfahren nach einem der Ansprüche 1 bis 4, **dadurch gekennzeichnet, daß** eine leitende Verbindung zwischen dem Kontaktfeld (2,5) und den Kontakten des integrierten Schaltkreises (4) mittels Bonddrähtchen (12, 22) hergestellt wird.

7. Verfahren nach Anspruch 6, **dadurch gekennzeichnet, daß** die Bonddrähtchen (2) an die Kontakte des integrierten Schaltkreises (4) und an dafür vorgesehene Bereiche des Kontaktfeldes (2, 5) gebondet werden.

8. Verfahren nach Anspruch 6, **dadurch gekennzeichnet, daß** die Bonddrähtchen (22) an die Kontakte des integrierten Schaltkreises (4) angebondet werden und an Bereiche der Kartenoberfläche geführt werden, in denen die dafür vorgesehenen Bereiche des Kontaktfeldes (2, 5) zu liegen kommen.

9. Vorrichtung zum Aufpressen von Kontaktmitteln (2, 5) zur Kommunikation mit externen Geräten auf einen kartenförmigen Datenträger (1), wobei die Vorrichtung umfasst:
- Mittel zum Einsetzen eines integrierten Schaltkreises (4),
- Mittel zum Aufbringen eines Kontaktmittels (2, 5) von einem Transferband (13) auf einen Kartenkörper (1),
- Mittel zur Herstellung von leitenden Verbindungen zwischen dem Kontaktmittel (2, 5) und den Kontakten des integrierten Schaltkreises,
**gekennzeichnet durch**
- Mittel zum Auffüllen eines Hohlraumes mit einer Vergussmasse (3), so dass sich eine ebene Oberfläche ergibt,
wobei
**das** Kontaktmittel (2, 5) aus einem Kontaktfeld mit einer Anzahl elektrisch voneinander isolierter Kontaktflächen besteht.

## Claims

1. A method for producing a contact-type card-shaped data carrier (1) having an integrated circuit (4) and contact means (2, 5) connected conductively to the integrated circuit (4) for communication with external devices, whereby
- a card body is supplied, having at least one recess for receiving the integrated circuit (4),
- the integrated circuit (4) is inserted into the recess,
- the contact means (2, 5) is transferred to the card body from a transfer band (13) before or after insertion of the integrated circuit into the recess, by a stamp (10) pressing the transfer band (13) with the contact means (2, 5) against the card-shaped data carrier (1) from the side opposite the contact means (2, 5),
- a conductive connection is produced between the contact means (2, 5) and the contacts of the integrated circuit (4),
**characterized in that**
- the contact means (2, 5) consists of a contact pad with a number of mutually electrically insulated contact surfaces,
- after insertion of the integrated circuit (4), application of the contact pad (2, 5) and production of the conductive connections, the remaining cavity of the recess is filled with a casting compound (3) in such a way that a flat surface results.

2. The method according to claim 1, **characterized in that** the transfer band (13) consists of a carrier film (8) and a separating layer (7) disposed between the carrier film (8) and the contact pad (2, 5).

3. The method according to claim 2, **characterized in that** before the contact pad (2, 5) is pressed on, the transfer band (13) is positioned relative to the card-shaped data carrier (1) such that the contact pad (2, 5) comes to lie above the areas of the card-shaped data carrier (1) intended therefor.

4. The method according to any of the previous claims, **characterized in that** the contact pad (2, 5) is glued to the card-shaped data carrier (1).

5. The method according to any of the previous claims, **characterized in that** a conductive connection is produced between the contact pad (2, 5) and the contacts of the integrated circuit (4) by means of a conductive adhesive or by solder beads.

6. The method according to any of claims 1 to 4, **characterized in that** a conductive connection is produced between the contact pad (2, 5) and the contacts of the integrated circuit (4) by means of bonding wires (12, 22).

7. The method according to claim 6, **characterized in that** the bonding wires (2) are bonded to the contacts of the integrated circuit (4) and to areas of the contact pad (2, 1) intended therefor.

8. The method according to claim 6, **characterized in** the bonding wires (22) are bonded to the contacts of the integrated circuit (4) and guided to areas of the card surface where the areas of the contact pad (2, 5) intended therefor come to lie.

9. An apparatus for pressing contact means (2, 5) for communication with external devices onto a card-shaped data carrier (1), whereby the apparatus comprises:
- means for inserting an integrated circuit (4),
- means for applying a contact means (2, 5) from a transfer band (13) to a card body (1),
- means for producing conductive connections between the contact means (2, 5) and the contacts of the integrated circuit,
**characterized by**
- means for filling a cavity with a casting compound (3) so that a flat surface results,
whereby the contact means (2, 5) consists of a contact pad with a number of mutually electrically insulated contact surfaces.

## Revendications

1. Procédé pour la fabrication d'un support de données (1) en forme de carte et équipé de contact avec un circuit (4) intégré et des moyens de contact (2, 5) reliés de façon conductrice au circuit (4) intégré pour la communication avec des appareils externes,
- un corps de carte étant mis à disposition, avec au moins un évidement pour le logement du circuit (4) intégré,
- le circuit (4) intégré étant inséré dans l'évidement,
- le moyen de contact (2, 5) étant transféré d'une bande de transfert (13) sur le corps de carte avant ou après l'insertion du circuit intégré dans l'évidement par le fait qu'un poinçon (10) presse la bande de transfert (13) avec le moyen de contact (2, 5) à partir du côté opposé au moyen de contact (2, 5) contre le support de données (1) en forme de carte,
- une liaison conductrice étant établie entre le moyen de contact (2, 5) et les contacts du circuit intégré (4),
**caractérisé en ce que**
- le moyen de contact (2, 5) se compose d'une zone de contact avec un certain nombre de surfaces de contact isolées électriquement les unes des autres,
- l'espace creux restant de l'évidement est rempli avec une masse de scellement (3) après l'insertion du circuit (4) intégré, l'application de la zone de contact (2, 5) et la fabrication des liaisons conductrices de telle sorte qu'on obtient une surface plane.

2. Procédé selon la revendication 1, **caractérisé en ce que** la bande de transfert (13) se compose d'un film support (8) et d'une couche de séparation (7) disposée entre le film support (8) et la zone de contact (2, 5).

3. Procédé selon la revendication 2, **caractérisé en ce que** la bande de transfert (13) est positionnée avant le pressage de la zone de contact (2, 5) par rapport au support de données (1) en forme de carte de telle sorte que la zone de contact (2, 5) arrive au-dessus des zones prévues à cet effet du support de données (1) en forme de carte.

4. Procédé selon l'une quelconque des revendications précédentes, **caractérisé en ce que** la zone de contact (2, 5) est collée avec le support de données (1) en forme de carte.

5. Procédé selon l'une quelconque des revendications précédentes, **caractérisé en ce qu'**une liaison conductrice est établie entre la zone de contact (2, 5) et les contacts du circuit (4) intégré au moyen d'une colle conductrice ou au moyen de perles de brasage.

6. Procédé selon l'une quelconque des revendications 1 à 4, **caractérisé en ce qu'**une liaison conductrice est établie entre la zone de contact (2, 5) et les contacts du circuit (4) intégré au moyen de fils de liaison par fils soudés (12, 22).

7. Procédé selon la revendication 6, **caractérisé en ce que** fils de liaison par fils soudés (2) sont bondérisés sur les contacts du circuit intégré (4) et à des zones prévues à cet effet de la zone de contact (2, 5).

8. Procédé selon la revendication 6, **caractérisé en ce que** les petits fils de bondage (22) sont bondérisés sur les contacts du circuit (4) intégré et sont amenés sur des zones de la surface de carte, dans lesquelles arrivent les zones prévues à cet effet de la zone de contact (2, 5).

9. Dispositif pour le pressage de moyens de contact (2, 5) pour la communication avec des appareils externes sur un support de données (1) en forme de carte, le dispositif comprenant :
- des moyens pour l'insertion d'un circuit intégré (4),
- des moyens pour l'application d'un moyen de contact (2, 5) d'une bande de transfert (13) sur un corps de carte (1),
- des moyens pour la fabrication de liaisons conductrices entre le moyen de contact (2, 5) et les contacts du circuit intégré, **caractérisé par**
- des moyens pour le remplissage d'une cavité avec une masse de scellement (3), de sorte qu'on obtient une surface plane,
le moyen de contact (2, 5) étant composé d'une zone de contact avec un certain nombre de surfaces de contact isolées électriquement les unes des autres.
